(19) Europäisches Patentamt
European Patent Office
Office européen des brevets

(11) **EP 2 041 602 B1**

(12) **EUROPÄISCHE PATENTSCHRIFT**

(45) Veröffentlichungstag und Bekanntmachung des Hinweises auf die Patenterteilung:
**06.02.2013 Patentblatt 2013/06**

(21) Anmeldenummer: 07787286.9

(22) Anmeldetag: **10.07.2007**

(51) Int Cl.:
*G08G 1/052* (2006.01)     *G01S 13/92* (2006.01)
*G01S 7/02* (2006.01)     *G01S 7/35* (2006.01)
*G01S 7/36* (2006.01)     *G01S 13/91* (2006.01)
*H03L 7/099* (2006.01)     *H03L 7/14* (2006.01)
*H03L 7/18* (2006.01)     *G01S 7/41* (2006.01)
*G01S 13/536* (2006.01)     *G01S 13/56* (2006.01)
*G01S 13/34* (2006.01)     *G01S 13/538* (2006.01)

(86) Internationale Anmeldenummer:
**PCT/EP2007/057010**

(87) Internationale Veröffentlichungsnummer:
**WO 2008/006817 (17.01.2008 Gazette 2008/03)**

(54) **Verfahren und Vorrichtung zum Erfassen mindestens eines sich bewegenden Objekts.**

Method and device for the detection of at least one moving object.

Procédé et dispositif pour la détection d'au moins un objet qui se déplace.

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **13.07.2006 DE 102006032544**

(43) Veröffentlichungstag der Anmeldung:
**01.04.2009 Patentblatt 2009/14**

(73) Patentinhaber: **SIEMENS AKTIENGESELLSCHAFT**
**80333 München (DE)**

(72) Erfinder:
• **NALEZINSKI, Martin**
  **81541 München (DE)**
• **SEISENBERGER, Claus**
  **84181 Neufrannhofen (DE)**

(56) Entgegenhaltungen:
**EP-A2- 0 188 694     WO-A-2004/063682**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft ein Verfahren zum Erfassen mindestens eines sich bewegenden Objekts, eine Vorrichtung zur Präsenzdetektion und eine geschwindigkeitsabhängige Verkehrsanzeige mit einem Präsenzdetektor.

Bei der Präsenzdetektion, insbesondere in Anwendungen in der Verkehrstechnik zur Fahrzeuganwesenheits-, -abstands- und -geschwindigkeitserfassung, kommen neben optischen Systemen Radarsensoren zum Einsatz. Diese Sensoren sind häufig aus Kostengründen Doppler-Radare, d. h. sogenannte Dauerstrich (Continuous Wave; CW)-Radare. Mit diesen CW-Radaren kann in der Praxis neben der Reflexionsamplitude nur eine Änderung der Reflexionsphase des reflektierenden Objekts bzw. Szenarios detektiert werden. Folglich kann also nur die Bewegung bzw. Geschwindigkeit eines Objektes gemessen werden.

Für manche Anwendungen, z. B. für die Abstands- oder Geschwindigkeitsüberwachung, ist es wünschenswert, die Geschwindigkeit von Fahrzeugen zu messen, die sich in einem bestimmten Abstandsbereich in der Nähe des Sensors befinden. Ggf. ist zusätzlich gewünscht, nur Objekte mit einer Geschwindigkeit in einem bestimmten Bereich zu detektieren. Dabei sollen die Grenzen häufig per Software einstellbar sein.

Eine bekannte Implementierung besteht darin, den Sensor mittels einer mechanischen Justage auf einen bestimmten Abstandsbereich zu justieren. Das bedeutet aber, dass für jede Umkonfigurierung des Detektionsbereichs ein Wartungstechniker Zugang zu dem Sensor erlangen muss. Im Verkehrsumfeld sind die Sensoren aber häufig schwer zugänglich, z. B. auf Ampelmasten oder Signalbrücken, montiert, wodurch der Zugriff auf den Sensor ein nennenswertes Problem darstellt, wenn der laufende Verkehr nicht gestört werden darf.

Eine weitere derzeitige Implementierung besteht darin, die Entfernung des Objektes mit Hilfe eines sogenannten frequenzmodulierten Dauerstrich ("Frequency Modulated Continuous Wave"; FMCW)-Radars zu messen. Ein Nachteil dabei ist, dass ein FMCW-Radar teurer ist als ein Doppler-Radar, da beim FMCW-Konzept eine durchstimmbare, geregelte Signalquelle benötigt wird, während beim Doppler-Konzept eine ungeregelte Festfrequenzsignalquelle ausreicht.

Des Weiteren liefert der Radarsensor nach dem FMCW-Prinzip eine Überlagerung des Abstands- und des Geschwindigkeits(doppler)-Signals. Dabei kann es beispielsweise passieren, dass die FMCW-Dopplerfrequenz aufgrund der Bewegungsrichtung des Messobjektes negativ und die FMCW-Abstandsfrequenz positiv und im Betrag kleiner ist. Dann kommt das überlagerte Signal im negativen Frequenzbereich zu liegen. Eine Trennung der beiden Signale bedingt eine aufwändige Signalverarbeitung, die sich wiederum in hohen Hardwarekosten niederschlägt.

Eine vereinfachte Implementierung nach dem FMCW-Prinzip besteht darin, abwechselnd eine Geschwindigkeits- und eine Abstandsmessung durchzuführen. Diese Methode funktioniert allerdings nur dann, wenn sich nur ein Fahrzeug im Detektionsbereich befindet. Sobald sich mehrere Fahrzeuge im Messbereich befinden, ist die Zuordnung von gemessenen Geschwindigkeiten und Abständen kaum lösbar.

Aus der Druckschrift WO 2004/063682 A2 sind ein System und ein Verfahren zur Messung der Geschwindigkeit und/oder der Richtung eines Zieles bekannt wie beispielsweise von einem Fahrzeug innerhalb eines Sichtfeldes. Die Geschwindigkeit eines Fahrzeuges wird unter Einsatz von Abstandsmessverfahren wie Phasenmessung oder Doppler-Verschiebungsmessung unter Einsatz eines Einzelmesswandlers, der von der Seite her misst, festgestellt. Insbesondere wird die Geschwindigkeit eines Objektes mittels einer Reihe von Distanzmessungen und von mathematischen Gleichungen abgeschätzt.

Es ist die Aufgabe der vorliegenden Erfindung, eine Möglichkeit zur einfachen, robusten und kostengünstigen Präsenzdetektion auch bei Vorhandensein mehrerer Fahrzeuge in einem Detektionsbereich bereitzustellen.

Diese Aufgabe wird durch ein Verfahren nach Anspruch 1, einen Präsenzdetektor nach Anspruch 8 und eine geschwindigkeitsabhängige Verkehrsanzeige nach Anspruch 10 gelöst.

Das Verfahren zum Erfassen mindestens eines sich bewegenden Objekts in einem vorbestimmten Detektionsbereich mittels eines Geschwindigkeitssensors, weist mindestens die folgenden Schritte auf:

- Festsetzen eines Erfassungsbereichs innerhalb eines Ausleuchtbereichs des Geschwindigkeitssensors;
- Erfassen eines Geschwindigkeitssignals, insbesondere eines Dopplersignals, zumindest bei Eintritt eines sich bewegenden Objekts in den Ausleuchtbereich;
- Abschätzen eines Eintritts des sich bewegenden Objekts in den Detektionsbereich auf der Grundlage einer, gemessenen oder tatsächlichen, Geschwindigkeit des Objekts und eines Abstands zwischen dem Ausleuchtbereich und dem Detektionsbereich.

Das Verfahren kann mittels eines kostengünstigen und robusten Sensors, z. B. eines Dopplerradars, aber auch eines FMCW-Radars, durchgeführt werden.

Zudem kann die Länge des Detektionsbereichs unabhängig vom Öffnungswinkel der Antenne (welche unter anderem den Ausleuchtbereich bestimmt) gewählt werden, wobei sowohl der Beginn als auch das Ende des Detektionsbereichs weitgehend frei innerhalb des Ausleuchtbereichs gewählt werden können. Dies kann insbesondere günstig durch eine rein elektronische Einstellung des Sensors geschehen. Der Detektionsbereich kann damit auch weitgehend unabhängig von der Montageposition des Detektors gewählt werden.

Bevorzugt wird ein Verfahren, bei dem der Schritt des Festsetzens des Erfassungsbereichs ein Festsetzen eines Erfassungsbereichs abhängig von einer Geschwindigkeit des Objekts umfasst. Der Detektionsbereich kann somit dynamisch mit der Objekt-, insbesondere Fahrzeuggeschwindigkeit, verändert werden. Damit ist es z. B. möglich, den Detektionsbereich nicht örtlich, sondern zeitlich festzulegen. Mit dem beschriebenen Verfahren ist es z. B. möglich, die Detektion z. B. 5 Sekunden vor Erreichen einer Markierungslinie auszulösen und 1 Sekunde vor Erreichen dieser Linie die Detektion wieder zurückzunehmen.

Bevorzugt wird ferner ein Verfahren bei dem bei höherer Geschwindigkeit des Objekts der Abstand zwischen dem Ausleuchtbereich und dem Detektionsbereich verringert wird. Vorteilhaft ist dies insbesondere für eine geschwindigkeitsabhängig angezeigte Warninformationen, um den Fahrern eine ausreichend lange Visualisierung auch bei hohen Geschwindigkeiten zu ermöglichen.

Bevorzugt wird auch ein Verfahren, das zusätzlich einen Schritt eines Verringerns, insbesondere einer im Wesentlichen vollständigen Beseitigung, einer Winkelabhängigkeit der gemessenen Geschwindigkeit des Objekts aufweist.

Bevorzugt wird dazu ein Verfahren, bei dem die gemessene Geschwindigkeit des Objekts mit einer Geometriefunktion kalibriert wird, insbesondere mittels einer in einer Nachschlagetabelle punktweise hinterlegten Geometriefunktion. Die Geometriefunktion kann beispielsweise unter Kenntnis der Sensorposition und der Objektposition mittels eines Triangulationsverfahrens berechnet werden. Insbesondere umfasst die Geometriefunktion eine Information über einen Winkel zwischen der Achse, die vom Geschwindigkeitssensor zum Objekt läuft, und der Richtung des Geschwindigkeitsvektors.

In einer Ausführungsform braucht die Geschwindigkeit nur einmal bei Eintritt in die Ausleuchtzone bestimmt und dann als konstant angenommen werden. Zur genaueren Bestimmung der Objektposition wird es bevorzugt, wenn die Geschwindigkeit des Objekts auch im Ausleuchtbereich bestimmt wird, insbesondere kontinuierlich neu berechnet wird. Dabei wird unter 'kontinuierlich' z. B. auch eine Neuberechnung in regelmäßigen Abständen verstanden.

Vorzugsweise ist das Verfahren zur Verwendung bei einer Anzeige einer von der Geschwindigkeit des Objekts abhängigen Warninformation an Insassen des Objekts / Fahrzeugs vorgesehen.

Der Präsenzdetektor weist zur Erfassung mindestens eines sich bewegenden Objekts in einem vorbestimmten Detektionsbereich auf:

- einen Geschwindigkeitssensor zum Erfassen eines Geschwindigkeitssignals zumindest bei Eintritt eines sich bewegenden Objekts in einen Ausleuchtbereich des Geschwindigkeitssensors,

- eine Steuereinheit zum Festsetzen eines Erfassungsbereichs innerhalb eines Ausleuchtbereichs des Geschwindigkeitssensors und

- eine Auswerteeinheit zum Abschätzen eines Eintritts des sich bewegenden Objekts in den Detektionsbereich auf der Grundlage einer gemessenen Geschwindigkeit (Vr) des Objekts und eines Abstands zwischen dem Ausleuchtbereich und dem Detektionsbereich.

Vorzugsweise umfasst der Geschwindigkeitssensor ein Doppler-radar, insbesondere ein FMCW-Radar.

Die geschwindigkeitsabhängige Verkehrsanzeige ist mit einem solchen Präsenzdetektor ausgestattet.

Im Folgenden wird die Erfindung schematisch anhand eines Ausführungsbeispiels genauer beschrieben.

FIG 1　zeigt eine Skizze eines Aufbaus einer Vorrichtung zur Präsenzdetektion von Objekten in einem Detektionsbereich eines Sensors in Seitenansicht;

FIG 2　zeigt eine Auftragung einer vom Sensor aus FIG 1 erfassten Geschwindigkeit eines Objekt im in Abhängigkeit eines Winkels zwischen der Sichtlinie Objekt-Sensor und eines dem Objekt zugeordneten Geschwindigkeitssensors.

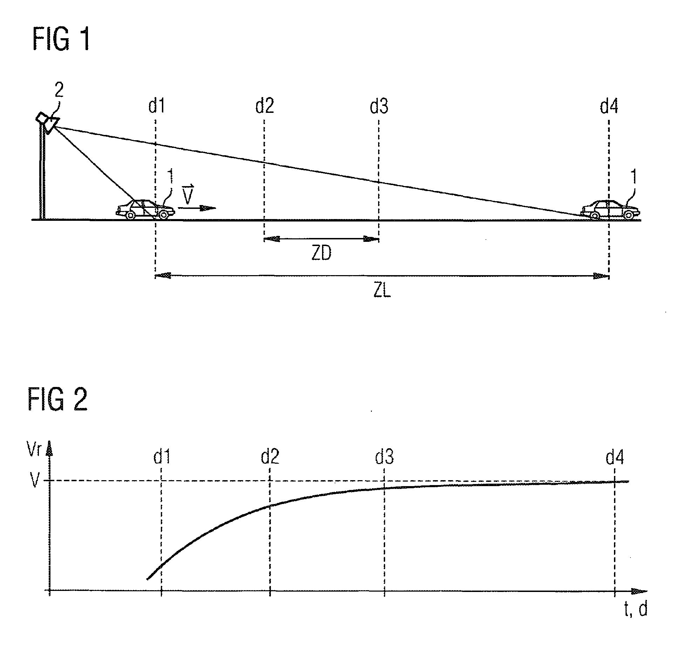

In FIG 1 ist eine Vorrichtung zur Präsenzdetektion von Fahrzeugobjekten 1 gezeigt, die einen erhöht angebrachten dopplerfähigen Geschwindigkeitssensor 2 umfasst. Da die Antennencharakteristik des Geschwindigkeitssensors 1 bekannt ist, sind eine vordere Grenze d1 und eine hintere Grenze d4 eines vom Geschwindigkeitssensor 2 ausgeleuchteten Bereichs ZL bekannt. Die Form des Ausleuchtbereichs ZL ist bei kreisförmiger Antennenstrahlcharakteristik und schrägem Sensor 2 allgemein oval.

Die Grenzen d1, d4, innerhalb derer Fahrzeuge 1 erkannt werden können, sind relativ scharf begrenzt. Sobald also durch den Geschwindigkeitssensor 1 eine Dopplerfrequenz messbar wird, bedeutet dies, dass ein Objekt (Fahrzeug) 1 bei d1 oder d4 in den Ausleuchtbereich ZL einfährt und seine Geschwindigkeit v messbar ist. Sobald das Dopplersignal wieder verschwindet, hat das Fahrzeug 1 die entsprechende zweite Grenze d4 bzw. d1 des Ausleuchtbereichs ZL erreicht und verlässt diesen wieder. Nachdem zu jedem Zeitpunkt die Geschwindigkeit v des Messobjektes 1 bekannt ist, kann aus dem Zeitpunkt des Eintritts in das beleuchtete Gebiet ZL, der Geschwindigkeit v und der seit dem Eintritt verstrichenen Zeit die augenblickliche Position des Fahrzeugs 1 ermittelt werden. Je schärfer die Ausleuchtungszone ZL begrenzt ist, desto genauer kann die Position des Fahrzeugs 2 bei Eintritt in den Ausleuchtbereich ZL ermittelt werden.

In dieser Ausführungsform wird am Geschwindigkeitssensor 2 ferner ein Detektionsbereich bzw. -tor ZD eingestellt, der sich in der Ausleuchtzone ZL befindet. Der Detektionsbereich wird z. B. elektronisch am Geschwindigkeitssensor 2 zwischen den Grenzen d2 und d3 eingestellt.

Das Erreichen der Grenze d2 des Detektionsbereichs ZD von d1 kommend errechnet sich (bei annähernd linearem Weg des Fahrzeugs 1) zu

$$d2 = d1 + V \cdot t,$$

mit V der Geschwindigkeit des Fahrzeugs 1 und t der verstrichenen Zeit. Dabei kann beispielsweise auf einen Vergleich einer tatsächlichen Position dF des Fahrzeugs 1 mit d2 abgestellt werden, oder auf einen Zeitvergleich zwischen einer verstrichenen Zeit tF seit Einfahrt in den Ausleuchtbereich ZL mit der zum Erreichen des Detektionsbereichs ZD nötigen Zeit t = (d2-dl)/V.

Aus FIG 1 ergibt sich, dass sich die vom Sensor 2 gemessene Geschwindigkeit Vr während einer Fahrt des Fahrzeugs 1 mit konstanter Geschwindigkeit V durch die beleuchtete Zone ZL in Abhängigkeit vom lokalen Winkel zwischen der Sichtlinie des Sensors 2 zum Fahrzeug 1 und der Fahrtrichtung des Fahrzeugs 1 ändert. Diese Winkelabhängigkeit ist für praktische Anwendungen häufig ausreichend klein ist, so dass ein Messfehler ausreichend klein bleibt; dann kann ohne wesentliche Einschränkung V = Vr gesetzt werden.

Alternativ kann die Winkelabhängigkeit der gemessenen Geschwindigkeit Vr bzw. kann die Differenz der gemessenen Geschwindigkeit Vr gegen die tatsächliche Fahrzeuggeschwindigkeit V herauskorrigiert werden. Die gemessene Geschwindigkeit Vr bei tatsächlich konstanter Geschwindigkeit V des Fahrzeugs 1 ist in FIG 2 über die Zeitdauer t bzw. den Abstand d von der Grenze d1 seit Erreichen der Ausleuchtzone ZL bei d1 aufgetragen. Die in FIG 2 gezeigte Auftragung K kann beispielsweise einmalig ermittelt und dann - ggf. punktweise - als Kalibrationskurve zur Geschwindigkeitskorrektur verwendet werden.

Befinden sich mehrere Fahrzeuge 1 im Ausleuchtbereich ZL zwischen d1 und d4, so sind sie nur dann nicht zu unterscheiden, wenn sie die gleiche Geschwindigkeit V bzw. Vr aufweisen. Andernfalls ergeben sich mehrere Dopplerfrequenzen, die getrennt verfolgt werden können. In ersterem Fall ist es in der Regel aber unerheblich, dass die Fahrzeuge 1 nicht mehr unterscheidbar sind, weil sich dann immer ein Fahrzeug 1 im Detektionsbereich befindet.

**Patentansprüche**

1. Verfahren zum Erfassen mindestens eines sich bewegenden Objekts (1) in einem vorbestimmten Detektionsbereich (ZD) mittels eines Geschwindigkeitssensors (2), das folgende Schritte aufweist:

  - Festsetzen eines Detektionsbereichs (ZD) innerhalb eines Ausleuchtbereichs (ZL) des Geschwindigkeitssensors (2);
  - Erfassen eines Geschwindigkeitssignals, insbesondere eines Dopplersignals, zumindest bei Eintritt eines sich bewegenden Objekts (1) in den Ausleuchtbereich (ZL);
  - Abschätzen eines Eintritts des sich bewegenden Objekts (1) in den Detektionsbereich (ZD) auf der Grundlage einer Geschwindigkeit (V; Vr) des Objekts (1) und eines Abstands (d) zwischen einer Grenze (d1; d4) des Ausleuchtbereichs (ZL) und dem Detektionsbereich (ZD).

2. Verfahren nach Anspruch 1, bei dem der Schritt des Festsetzens des Detektionsbereichs (ZD) ein Festsetzen eines Detektionsbereichs (ZD) abhängig von einer Geschwindigkeit (V; Vr) des Objekts (1) umfasst.

3. Verfahren nach Anspruch 2, bei dem bei höherer Geschwindigkeit (V; Vr) des Objekts der Abstand zwischen der Grenze (d1; d4) des Ausleuchtbereichs (ZL) und dem Detektionsbereich (ZD) verringert wird.

4. Verfahren nach einem der vorhergehenden Ansprüche, zusätzlich aufweisend einen Schritt eines Verringerns einer Winkelabhängigkeit der gemessenen Geschwindigkeit (Vr) des Objekts (1).

5. Verfahren nach Anspruch 4, bei dem die gemessene Geschwindigkeit (Vr) des Objekts (1) mit einer Geometriefunktion (K) kalibriert wird, insbesondere mittels einer in einer Nachschlagetabelle punktweise hinterlegten Geometriefunktion.

6. Verfahren nach einem der vorhergehenden Ansprüche, bei dem die Geschwindigkeit (V; Vr) des Objekts (1) kontinuierlich neuberechnet wird.

7. Verfahren nach einem der vorhergehenden Ansprüche zur Verwendung bei einer Anzeige einer von der Geschwindigkeit (v) des Objekts (1) abhängigen Warninformationen an Insassen des Objekts (1).

8. Präsenzdetektor zur Erfassung mindestens eines sich bewegenden Objekts (1) in einem vorbestimmten Detektionsbereich, aufweisend:

  - einen Geschwindigkeitssensor (2) zum Erfassen eines Geschwindigkeitssignals zumindest bei Eintritt eines sich bewegenden Objekts (1) in einen Ausleuchtbereich (ZL) des Geschwindigkeitssensors (2) ,
- eine Steuereinheit zum Festsetzen eines Erfassungsbereichs (ZD) innerhalb des Ausleuchtbereichs (ZL) des Geschwindigkeitssensors (2) und
- eine Auswerteeinheit zum Abschätzen eines Eintritts des sich bewegenden Objekts (1) in den Detektionsbereich (ZD) auf der Grundlage einer Geschwindigkeit (V; Vr) des Objekts (1) und eines Abstands zwischen einer Grenze (d1; d4) des Ausleuchtbereichs (ZL) und dem Detektionsbereich (ZD).

9. Präsenzdetektor nach Anspruch 8, bei dem der Geschwindigkeitssensor (2) ein Dopplerradar, insbesondere ein FMCW-Radar, umfasst.

10. Geschwindigkeitsabhängige Verkehrsanzeige mit einem Präsenzdetektor nach Anspruch 8 oder 9.


**Claims**

1. Method for detecting at least one moving object (1) in a predetermined detection zone (ZD) by means of a speed sensor (2), said method comprising the following steps of:

    - specifying a detection zone (ZD) within an illumination zone (ZL) of the speed sensor (2);
    - measuring a speed signal, in particular a Doppler signal, at least upon entry of a moving object (1) into the illumination zone (ZL);
    - estimating an entry of the moving object (1) into the detection zone (ZD) on the basis of a speed (V; Vr) of the object (1) and a distance (d) between a boundary (d1; d4) of the illumination zone (ZL) and the detection zone (ZD).

2. Method according to claim 1, wherein the step of specifying the detection zone (ZD) includes specifying a detection zone (ZD) as a function of a speed (V; Vr) of the object (1).

3. Method according to claim 2, wherein at a higher speed (V; Vr) of the object the distance between the boundary (d1; d4) of the illumination zone (ZL) and the detection zone (ZD) is reduced.

4. Method according to one of the preceding claims, additionally comprising a step of reducing an angle dependence of the measured speed (Vr) of the object (1).

5. Method according to claim 4, wherein the measured speed (Vr) of the object (1) is calibrated using a geometry function (K), in particular using a geometry function stored point by point in a lookup table.

6. Method according to one of the preceding claims, wherein the speed (V; Vr) of the object (1) is continually recalculated.

7. Method according to one of the preceding claims for use in a display of warning information that is dependent on the speed (v) of the object (1) to occupants of the object (1).

8. Presence detector for detecting at least one moving object (1) in a predetermined detection zone, comprising:

    - a speed sensor (2) for measuring a speed signal at least upon entry of a moving object (1) into an illumination zone (ZL) of the speed sensor (2),
    - a control unit for specifying a detection zone (ZD) within the illumination zone (ZL) of the speed sensor (2), and
    - an evaluation unit for estimating an entry of the moving object (1) into the detection zone (ZD) on the basis of a speed (V; Vr) of the object (1) and a distance between a boundary (d1; d4) of the illumination zone (ZL) and the detection zone (ZD).

9. Presence detector according to claim 8, wherein the speed sensor (2) includes a Doppler radar, in particular an FMCW radar.

10. Speed-dependent traffic display having a presence detector according to claim 8 or 9.


**Revendications**

1. Procédé de détection d'au moins un objet qui se déplace (1) dans une zone de détection (ZD) prédéfinie au moyen d'un capteur de vitesse (2), comprenant les étapes suivantes :

    - définition d'une zone de détection (ZD) à l'intérieur d'une zone éclairée (ZL) du capteur de vitesse (2) ;
    - détection d'un signal de vitesse, en particulier d'un signal Doppler, au moins à l'entrée d'un objet qui se déplace (1) dans la zone éclairée (ZL) ;
    - estimation d'une entrée de l'objet qui se déplace (1) dans la zone de détection (ZD) sur la base d'une vitesse (V ; Vr) de l'objet (1) et d'une distance (d) entre une limite (d1 ; d4) de la zone éclairée (ZL) et la zone de détection (ZD).

2. Procédé selon la revendication 1, dans lequel l'étape de définition de la zone de détection (ZD) comprend une définition d'une zone de détection (ZD) en fonction d'une vitesse (V ; Vr) de l'objet (1).

3. Procédé selon la revendication 2, dans lequel, à vitesse (V ; Vr) plus élevée de l'objet, la distance entre la limite (dol ; d4) de la zone éclairée (ZL) et la zone de détection (D) est diminuée.

4. Procédé selon l'une des revendications précédentes, comprenant en outre une étape de diminution d'une dépendance angulaire de la vitesse mesurée (Vr) de l'objet (1).

5. Procédé selon la revendication 4, dans lequel la vitesse mesurée (Vr) de l'objet (1) est calibrée à l'aide d'une fonction géométrique (K), en particulier à l'aide d'une fonction géométrique stockée point par point dans une table de consultation.

6. Procédé selon l'une des revendications précédentes, dans lequel la vitesse (V ; Vr) de l'objet (1) est recalculée en continu.

7. Procédé selon l'une des revendications précédentes destiné à être utilisé lors d'un affichage d'une information d'avertissement dépendante de la vitesse (v) de l'objet (1) adressée aux occupants de l'objet (1).

8. Détecteur de présence pour la détection d'au moins un objet qui se déplace (1) dans une zone de détection prédéfinie, comprenant :

   - un capteur de vitesse (2) destiné à détecter un signal de vitesse au moins à l'entrée d'un objet qui se déplace (1) dans une zone éclairée (ZL) du capteur de vitesse (2),
   - une unité de commande destinée à définir une zone de détection (ZD) à l'intérieur de la zone éclairée (ZL) du capteur de vitesse (2), et
   - une unité d'évaluation destinée à estimer une entrée de l'objet qui se déplace (1) dans la zone de détection (ZD) sur la base d'une vitesse (V ; Vr) de l'objet (1) et d'une distance entre une limite (d1 ; d4) de la zone éclairée (ZL) et la zone de détection (ZD).

9. Détecteur de présence selon la revendication 8, dans lequel le capteur de vitesse (2) comprend un radar Doppler, en particulier un radar FMCW.

10. Affichage du trafic dépendant de la vitesse doté d'un détecteur de présence selon la revendication 8 ou 9.

## FIG 1

## FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2004063682 A2